# EUROPEAN PATENT SPECIFICATION

(11) **EP 2 672 511 B1**
(45) Date of publication and mention of the grant of the patent: **09.12.2020**
(21) Application number: 12170759.0
(22) Date of filing: 04.06.2012
(51) Int. Cl.: H01L 21/98, H01L 21/768, H01L 25/065, H01L 21/683, H01L 23/48

(54) **3D STACKED MULTICHIP MODULE AND METHOD OF FABRICATION**
3D-MULTICHIP-MODUL UND DESSEN HERSTELLUNGSVERFAHREN
MODULE MULTIPUCE 3D ET SON PROCÉDÉ DE FABRICATION

(43) Date of publication of application: 11.12.2013
(73) Proprietor: MACRONIX INTERNATIONAL CO., LTD., Hsinchu (TW)
(72) Inventor: Chen, Shih-Hung, 310 HsinChu County (TW)
(74) Representative: Gunzelmann, Rainer

(56) References cited:
- EP-A2- 2 192 612
- US-A1- 2010 109 164
- US-A1- 2010 225 000
- US-A1- 2011 057 321

## Description

### BACKGROUND OF THE INVENTION

One type of three-dimensional integrated circuit (3D IC) is made using a number of semiconductor die stacked vertically and bonded to create the individual 3D ICs. Electrical connections from external bond pads to electrical conductors of the 3D ICs, and between electrical conductors of different layers of the 3D ICs, can be made using various methods. For example, in one wirebonding method the edges of adjacent chips can be staggered in a stair step fashion. This permits external bonding wires to be connected between pads on the chip and pads on a substrate.

Another method for making electrical connections between stacked chips, called through-silicon via (TSV), has generated significant interest. Interconnecting stacked chips by TSV has several advantages over conventional external wirebonding techniques. A stacked chip with TSV can exhibit a wider bandwidth and thus greater input/output compared to stacked chips connected via external wirebonding techniques. With TSV there is a shorter connection path which enhances speed and lowers power consumption.

TSV can be accomplished using wafer scale stacking with the aligned die separated or diced later. This provides for lower-cost, high throughput but it suffers from yield problems because the failure of one chip in a stack of chips causes that stack to fail resulting in lower yields. In addition, handling thinned down wafers is a manufacturing challenge that can result in damaged or destroyed product. TSV can also be accomplished using die scale stacking. This has the advantage that handling is relatively easy but at the expense of high cost.

Another disadvantage of conventional TSV is that a typical TSV process requires 11 steps for each die or wafer: TSV photoresist deposition, TSV etching, silicon dioxide deposition, barrier seed deposition, photoresist patterning, Cu/W deposition, photoresist removal, Cu/W chemical mechanical polishing, support/handling die bonding, die thinning, and bonding. In addition to the time and expense required for all the steps, the required handling and processing of each die results in lower yields.
US 2011/057321 A1 discloses a method for manufacturing a 3-D multi-wafer stacked semiconductor structure for improving the reliability issues. Therein, a plurality of wafers is stacked in a way that the connecting pads in different wafers are not align with each other. A conductor is then provided on the top surface of the stacked wafers to electrically couple the connecting pads in different wafers with each other.

### BRIEF SUMMARY OF THE INVENTION

A three-dimensional stacked module according to the present invention is provided in claim 1.
In some embodiments, the three-dimensional stacked module may also include one or more the following. At least some of the die comprise device circuitry at a device circuitry location spaced apart from the electrical contact region. A dielectric material layer is over the patterned conductor layer of the first die. The landing pads electrically contacted by the electrical connectors are arranged in a stair stepped arrangement.

As an example useful for understanding the present invention, a three-dimensional stacked multi-wafer module includes a stack of integrated circuit wafers, each integrated circuit wafer comprising a grid of die regions. At least some of the die regions for each integrated circuit wafer are aligned with die regions of the other integrated circuit wafers of the stack of integrated circuit wafers.

Claim 9 provides a first method for creating a three-dimensional stacked module according to the present invention.

In some embodiments, the first method for creating a three-dimensional stacked module may also include one or more the following. The forming step is carried out with at least some of the die comprising device circuitry at a device circuitry location spaced apart from the electrical contact region. The mounting step further comprises depositing a dielectric, adhesion-enhancing layer between the handling die and the die. The die is selected so that it comprises a substrate having a first side, at which the patterned conductor region is located, and a second side opposite the first side, the exposed layer being removed from the second side of the substrate. At least a portion of the handling die is removed from the three-dimensional stacked multichip module to create an exposed surface. A set of N etch masks are selected with N being selected so that 2^{N-1} is less than W and 2^{N} is greater than or equal to W; the N masks are used to etch the contact openings to the W die levels, the N masks using step comprising etching 2ⁿ⁻¹ die levels for effectively half of the contact openings for each mask n = 1, 2...N; and whereby electrical conductors can be formed in the contact openings to contact the electrical conductor elements at each of the die levels. The surface is covered with a dielectric material following the handling die removing step; and the contact openings creating step includes removing at least a portion of the dielectric material. The N etch masks using step further comprises alternatingly covering and exposing 2ⁿ⁻¹ landing pads for each mask n = 1, 2...N.

Claim 18 provides a second method for creating a plurality of three-dimensional stacked multichip modules according to the present invention

In some embodiments, the second method for creating a plurality of three-dimensional stacked multichip modules may also be carried out with the connectors forming step carried out as follows. A set of N etch masks is selected with N being selected so that 2^{N-1} is less than W and 2^{N} is greater than or equal to W. The N masks are used to etch the contact openings to the W die levels by etching 2ⁿ⁻¹ die levels for effectively half of the contact openings for each mask n = 1, 2...N. The N etch masks using step further comprises alternatingly covering and exposing 2ⁿ⁻¹ landing pads for each mask n = 1, 2...N.

Other features, aspects and advantages of the claimed invention can be seen on review the figures and the detailed description.

### BRIEF DESCRIPTION OF THE DRAWINGS

Fig. 1 is a simplified enlarged cross-sectional view of a portion of a die suitable for creating a 3D stacked multichip module illustrating the electrical contact region and device circuitry both within a patterned conductor layer, the device circuitry shown schematically and at a reduced scale, the device circuitry spaced apart from the electrical contact region.
Fig. 2 shows the structure of Fig. 1 after a handling die has been mounted to the patterned conductor layer of the die of Fig.1.
Fig. 3 shows the structure of Fig. 2 after a lower portion of the substrate of the die of Fig. 2 has been removed to create an enhanced handling die.
Fig. 4 shows the structure of Fig. 3 after the structure of Fig. 3 has been mounted on top of a further die, the further die being similar to the die of Fig. 1.
Fig. 5 shows the structure of Fig. 4 after a lower portion of the substrate of the die has been removed to create a stacked die.
Fig. 6 shows the results of repeating the processing steps of Figs. 4 and 5 creating a first 3D stacked die.
Fig. 7 shows the structure of Fig. 6 after the removal of at least a portion of the handling die of Fig. 6 creating a second 3D stacked die including an exposed surface.
Fig. 8 shows the structure of Fig. 7 after a dielectric material has been deposited on the exposed surface to create a third 3D stacked die.
Figs. 9-18 show a sequence of steps used to create vertically oriented electrical connectors in contact with the horizontally oriented electrical conductors at the different levels.

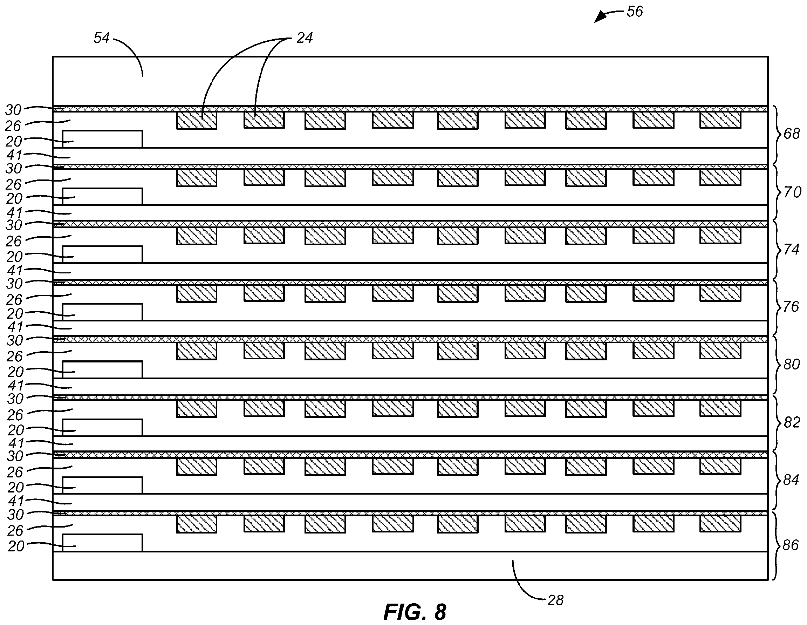

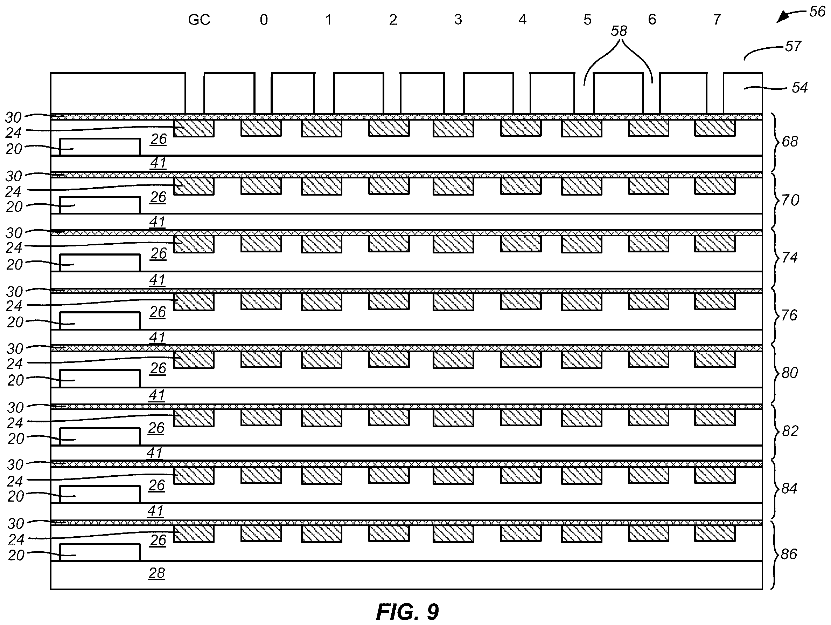

Fig. 9 shows the structure of Fig. 8 after creating openings in the dielectric material aligned with the ground conductor and electrical conductor locations.

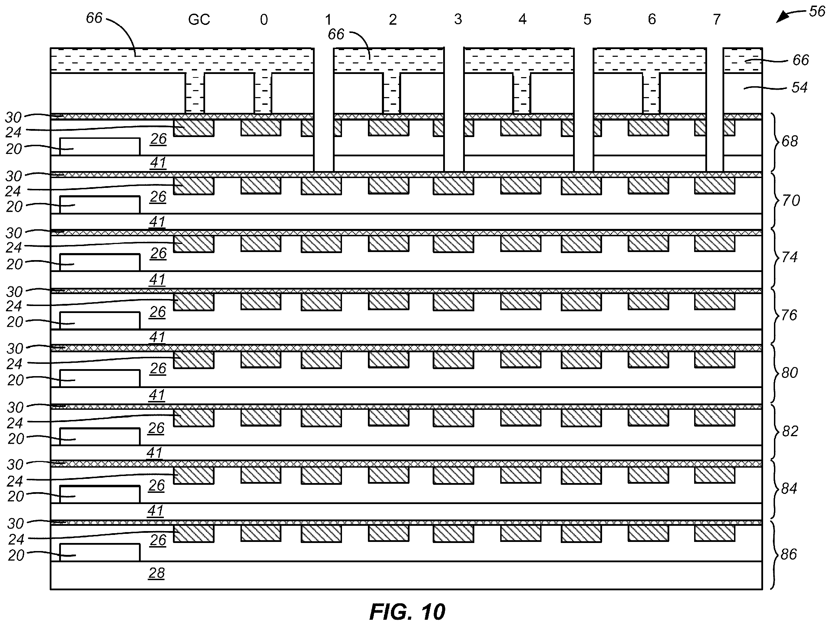

Fig. 10 illustrates the result of using a first photoresist mask and etching through one layer.

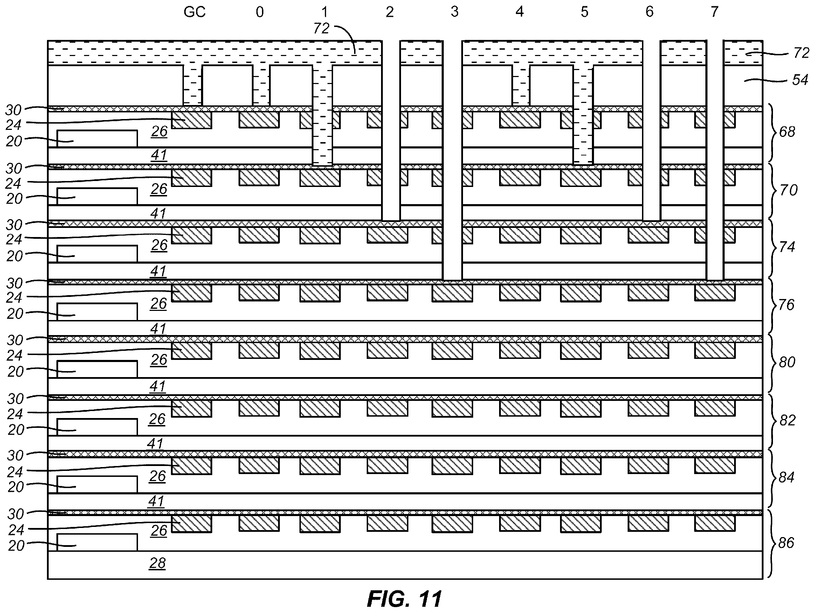

Fig. 11 illustrates results of using a second photoresist mask and etching through two layers.

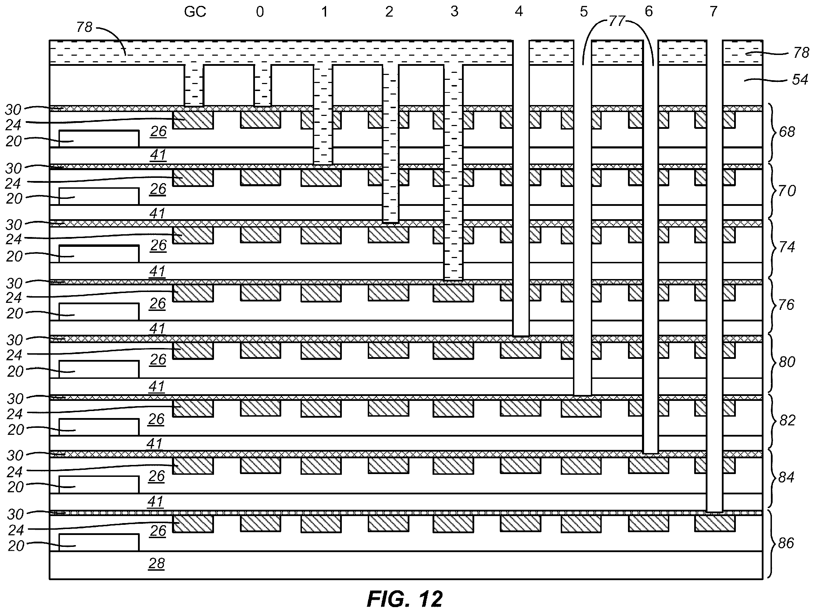

Fig. 12 shows a third photoresist mask and results of etching through four layers creating vias extending down to each level.

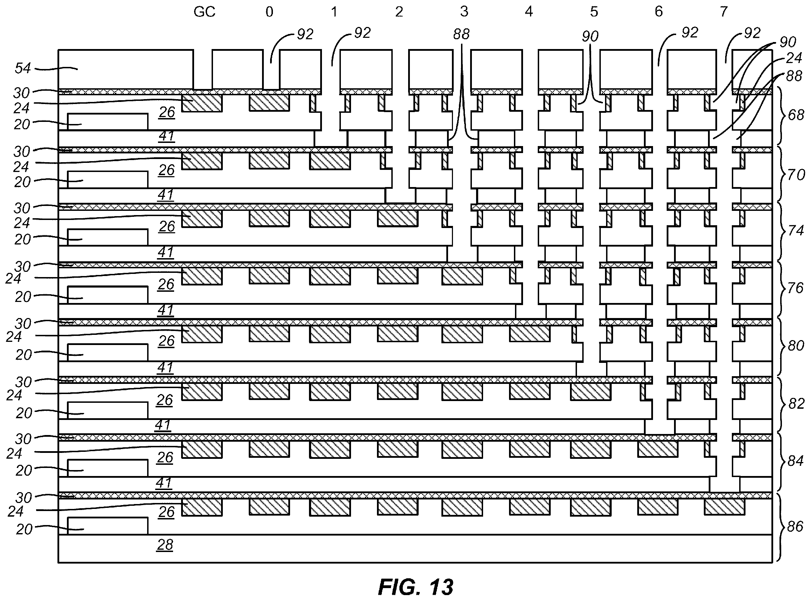

In Fig. 13 the third photoresist mask has been removed followed by etching of the vias.

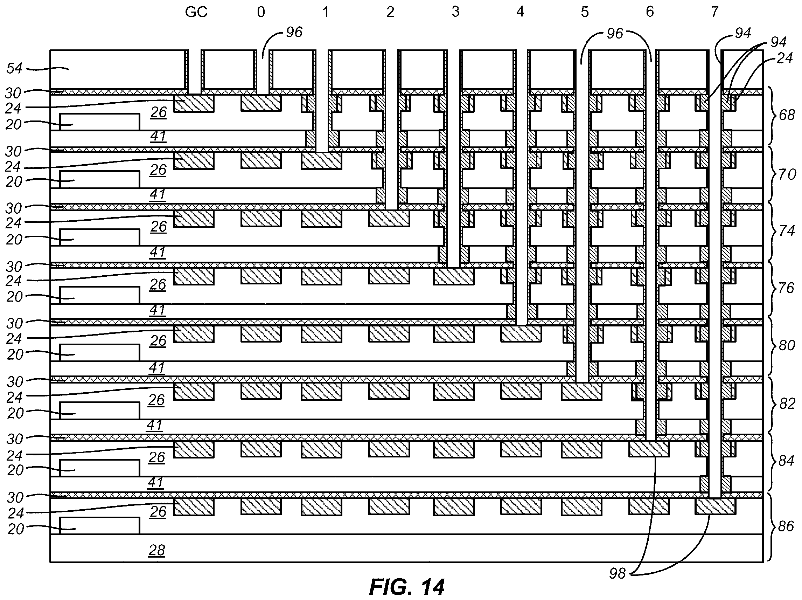

Fig. 14 shows result of lining the etched vias with a dielectric material.

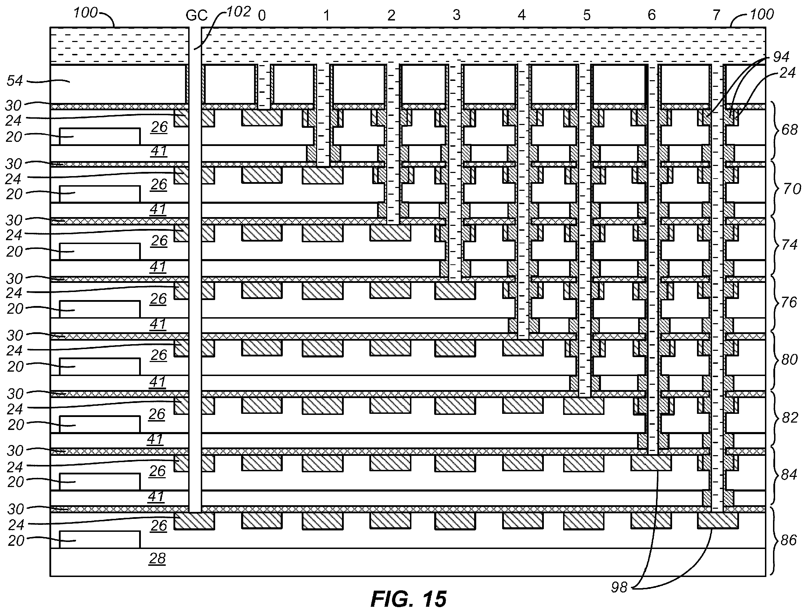

Fig. 15 illustrates a fourth photoresist mask covering the lined etched vias of Fig. 14 but exposing a ground conductor location and the result of etching through the levels down to the lowest conductor level.

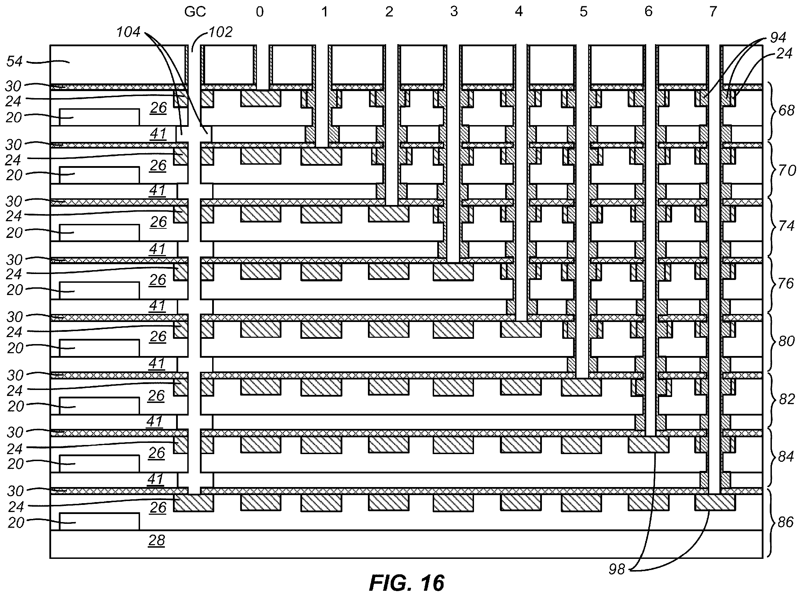

Fig. 16 shows result of an isotropic etching of substrate layers followed by the removal of the fourth photoresist mask.

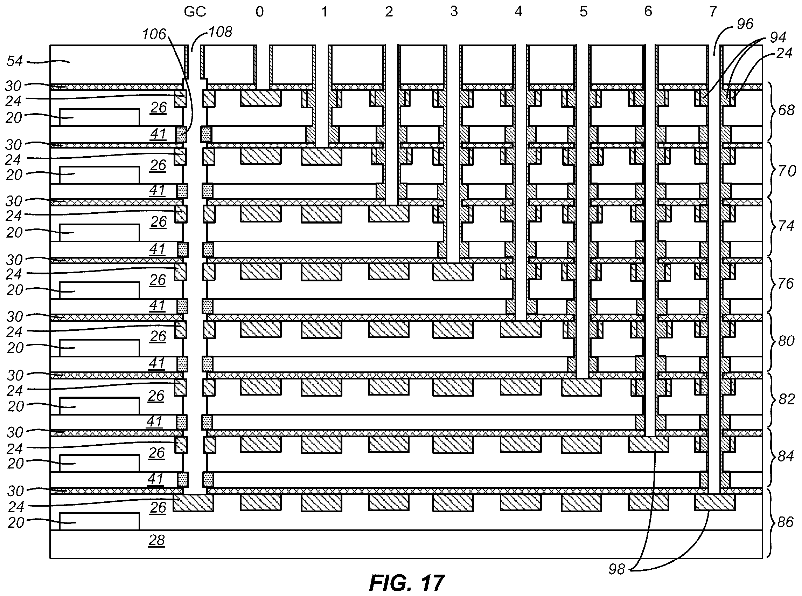

Fig. 17 illustrate an electrically insulating material deposited into the recessed regions formed in the step of Fig. 16 followed by etching back of the exposed dielectric material to create an enlarged ground conductor via.

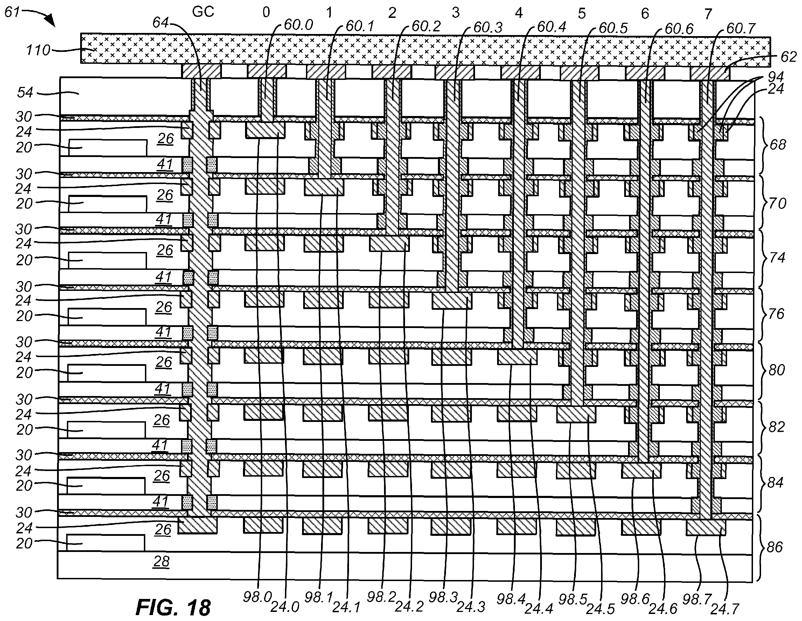

Fig. 18 shows the structure of Fig. 17 after filling the vias with a suitable electrical conductor to create a three-dimensional stacked IC assembly together with contact pads and a handling die on top of the stacked IC assembly.

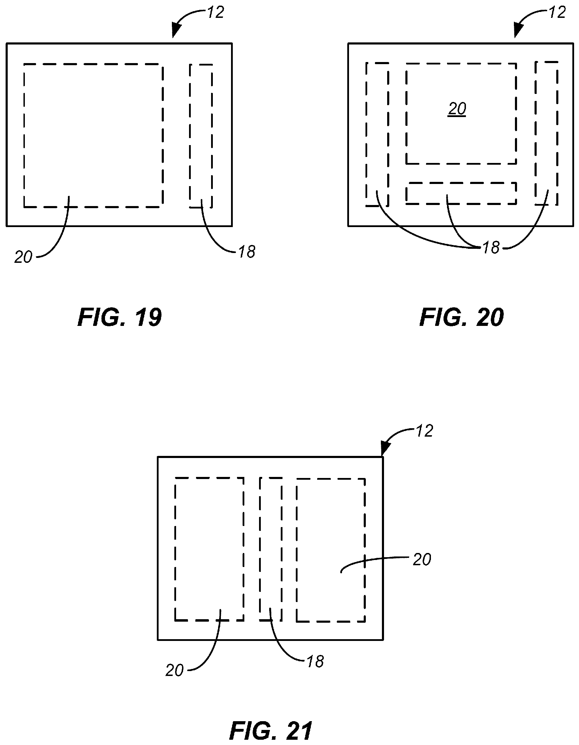

Figs. 19, 20 and 21 are simplified plan views of three examples of a die including one or more electrical contact regions and one or more regions with device circuitry.

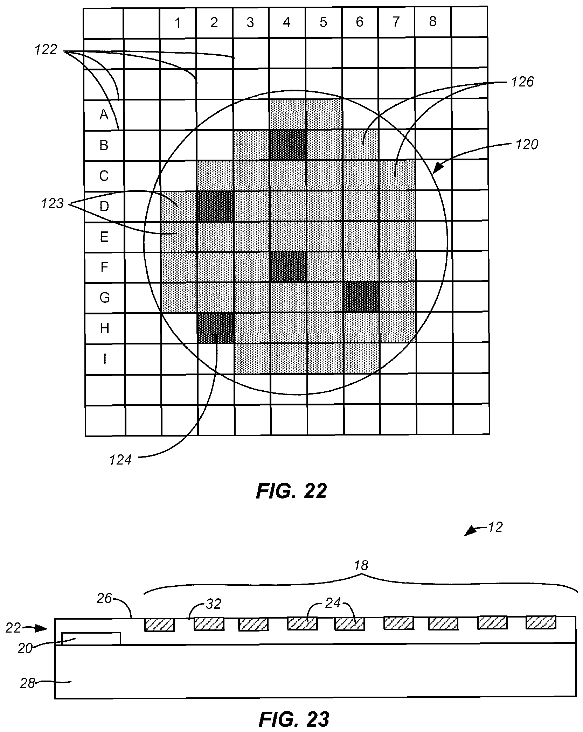

Fig. 22 is a top plan view of an IC wafer with a grid lines indicating die regions.
Fig. 23 is a side cross-sectional view of one of the die from the wafer of Fig. 22.

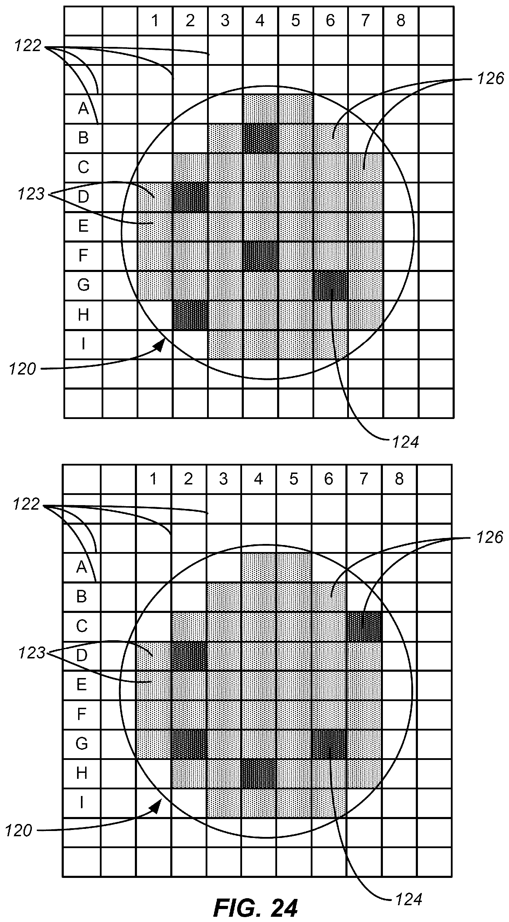

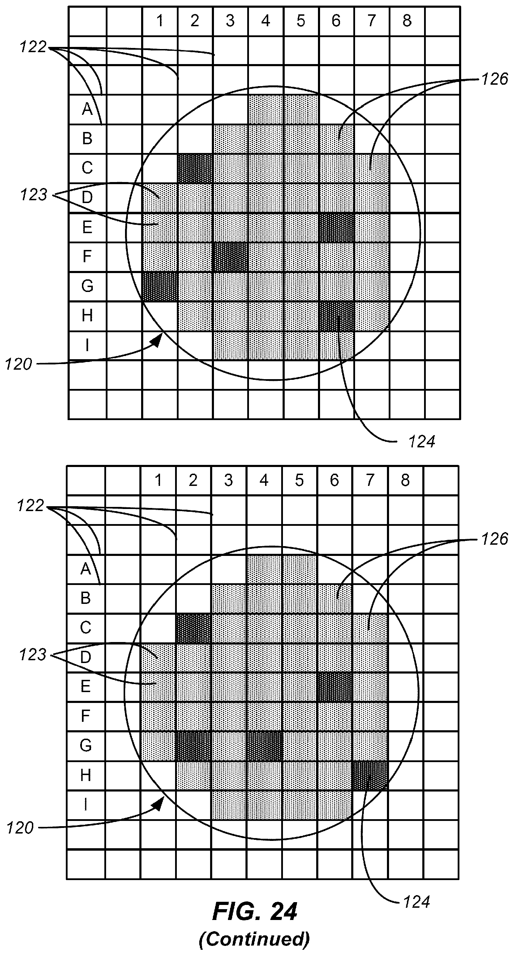

Fig. 24 illustrates an example in which four different wafers each having 90% good die and 10% bad die.

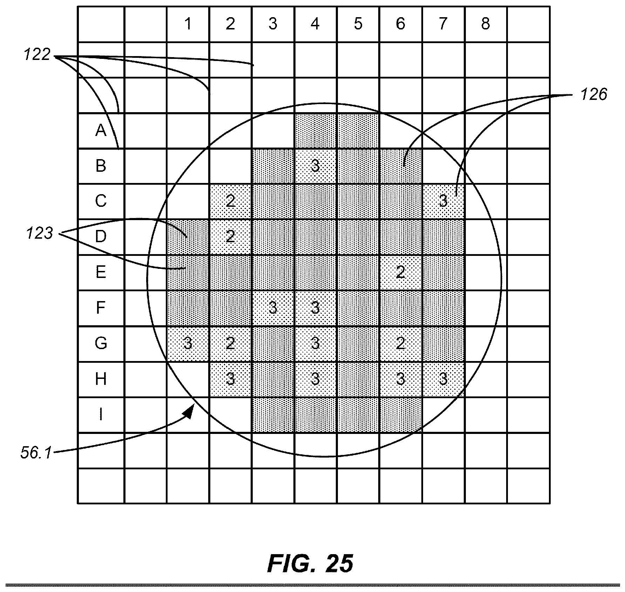

Fig. 25 illustrates results of stacking the four wafers of Fig. 24 with an indication of the number of good die within each die region having at least one bad die.

### DETAILED DESCRIPTION OF THE INVENTION

The following description will typically be with reference to specific structural embodiments and methods. It is to be understood that there is no intention to limit the invention to the specifically disclosed embodiments and methods but that the invention may be practiced using other features, elements, methods and embodiments. Preferred embodiments are described to illustrate the present invention, not to limit its scope, which is defined by the claims. Like elements in various embodiments are commonly referred to with like reference numerals.

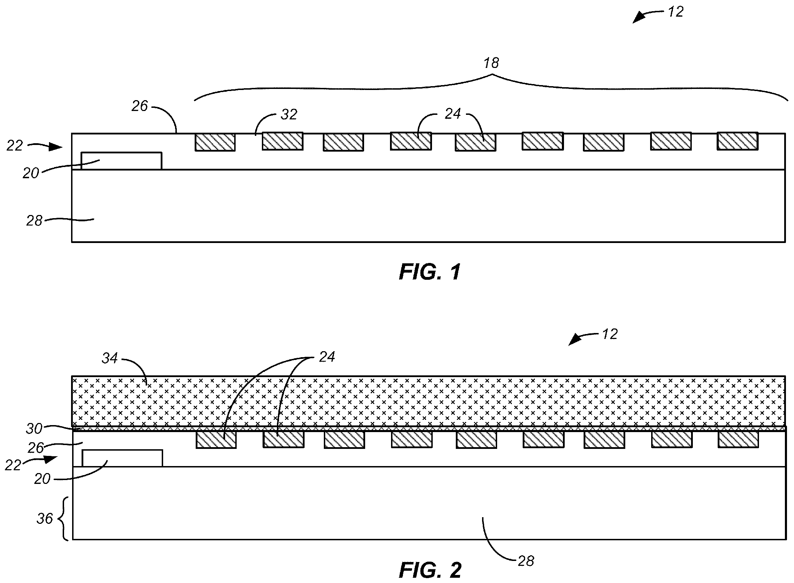

The present invention can be carried out using wafer scale stacking or die scale stacking. In Figs. 1-21, the invention will generally be described in terms of die scale stacking. The additional advantages which accrue from carrying out the invention using wafer scale stacking are described in the description of the present invention with respect to Figs. 22-25. Like reference numerals will be typically used when referring to like elements of dies and wafers.

Fig. 1 is a simplified enlarged cross-sectional view of an IC die 12 suitable for creating a 3D stacked multichip module as discussed below. Die 12 of Fig. 1 illustrates an electrical contact region 18 and schematically illustrates active device circuitry 20 for die 12, both within a patterned conductor layer 22. Patterned conductor layer 22 includes a dielectric layer 26 overlying and supported by a substrate 28 of die 12. Substrate 28 is typically silicon. Electrical contact region 18 includes a number of electrical conductors 24, typically made of a suitable metal such as copper or tungsten. Dielectric layer 26 is typically an oxide such as SiO₂. Electrical conductors 24 and device circuitry 20 are, in this example, formed in dielectric layer 26 and are spaced apart from one another by the material of dielectric layer 26. The active device circuitry 20, which includes circuits for the mission function of the die, is preferably spaced apart from the electrical contact region 18 and thus does not underlie electrical contact region 18. The active device circuitry 20 can comprise a flash memory circuit, another type memory circuit, an application specific circuit, a general purpose processor, a programmable logic device, combinations of circuit types as in a system of a chip device, and combinations of these and other types of circuits. In Fig. 1, active device circuitry 20 is illustrated as a relatively small element only for the purpose of the drawing. The relative size compared to the contact region 18 depends on the particular implementation.

Fig. 2 shows the die 12 of Fig. 1 after a hard mask layer 30 has been deposited on the upper surface 32 of patterned conductor layer 22 of Fig. 1. Hard mask layer 30 is an optional dielectric layer used for isolation and enhanced adhesion. A handling die 34 is mounted to hard mask layer 30 of die 12. Handling die 34 is preferably sufficiently thick and strong to help prevent damage to the underlying die 12, and subsequently added die 12, during the subsequent processing steps. Handling die 34 is typically a bare Si die. When wafer scale stacking is used, a handling wafer is mounted to wafer 12.1, typically on a hard mask layer corresponding to hard mask layer 30 applied to wafer 12.1. The handling wafer is preferably sufficiently thick and strong to help prevent damage to the underlying wafer 12.1, and subsequently added wafers 12.1, during the subsequent processing steps. The handling wafer is typically a bare Si wafer.

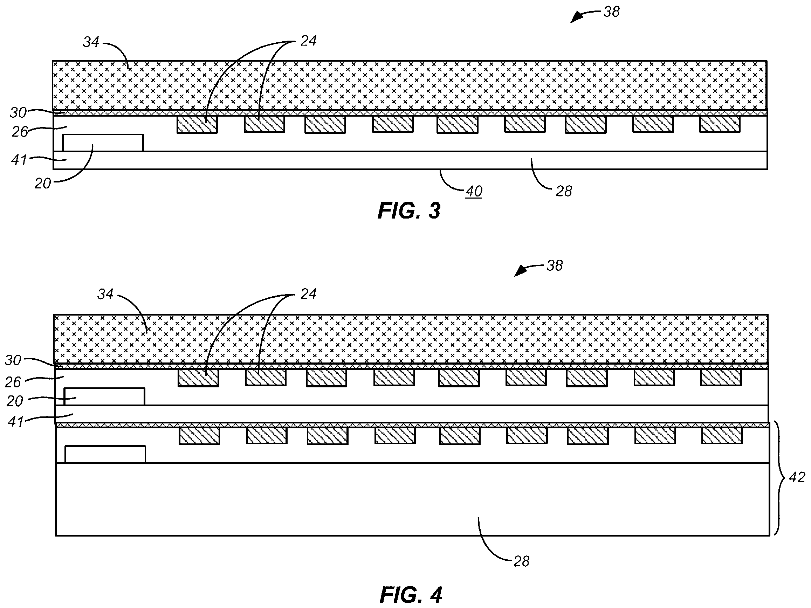

Fig. 3 shows the structure of Fig. 2 after a lower portion 36, see Fig. 2, of the substrate 28 of the die 12 of Fig. 2 has been removed to create an enhanced handling die 38 having a lower, bonding surface 40 on the remaining substrate 41. This die thinning step can be undertaken because of the strength provided to the underlying die 12 by handling die 34. During wafer scale operations, these operations would result in creation of an enhanced handling wafer corresponding to enhanced handling die 38.

Fig. 4 shows the enhanced handling die 38 of Fig. 3 mounted on top of a further die 42. Further die 42 is similar to the die 12 of Fig. 1 but preferably includes hard mask layer 30 formed on upper surface 32 of patterned conductor layer 22. Lower surface 40 of enhanced handling die 38 is mounted to hard mask layer 30 of further die 42. Similarly, during wafer scale operations, the lower surface of the enhanced handling wafer is mounted to the hard mask layer of the further wafer.

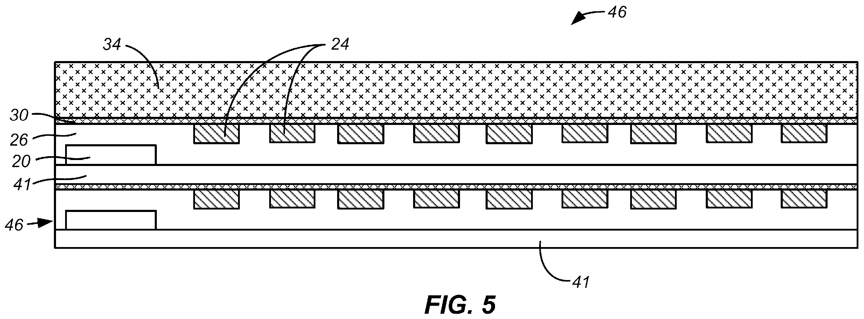

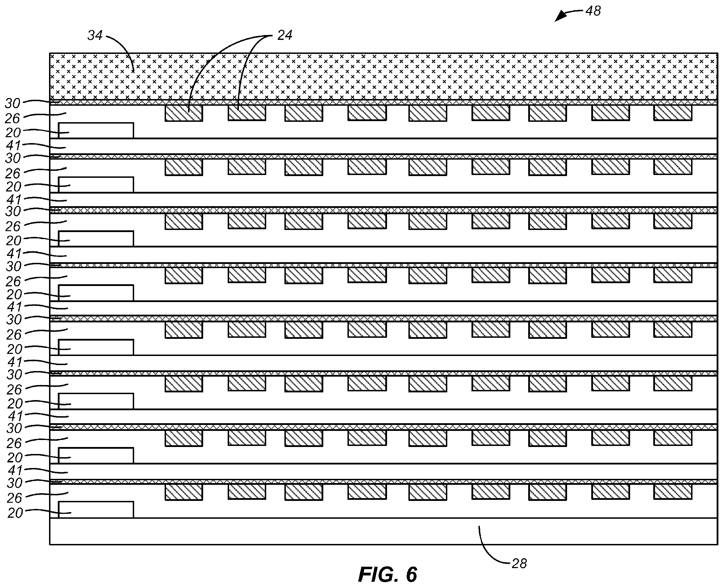

Fig. 5 shows the structure of Fig. 4 after the lower portion 36, see Fig. 4, of the substrate 41 of each of the die 12 has been removed to create a stacked die 46. Fig. 6 shows the results of repeating the processing steps of Figs. 4 and 5 using additional further die 42 to create a first 3D stacked die 48. One advantage resulting from reducing the thickness of stacked die 46 is that the depth of the via that must be etched and then filled, see Figs. 9-18, is reduced. This simplifies manufacturing because increasing the depth of the via often requires increasing the diameter of the via. In practice, the vias may be tapered and the technology for filling the vias become limiting with large aspect ratios (depth divided by the width of the via). During wafer scale operations, a stacked wafer is created in a similar manner followed by creation of a first 3-D stacked wafer.

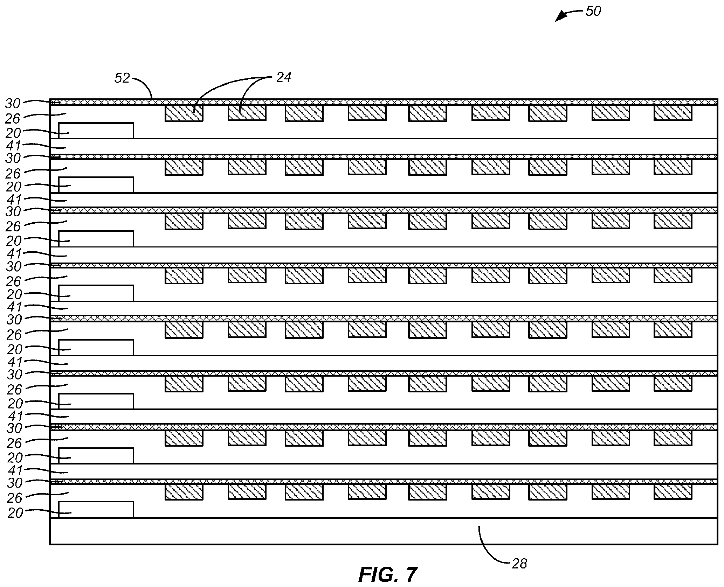

Fig. 7 shows the first 3D stacked die 48 of Fig. 6 after the removal of at least a portion of the handling die 34 of Fig. 6 creating a second 3D stacked die 50 with an exposed surface 52. Fig. 8 shows the structure of Fig. 7 after a dielectric material 54 has been deposited on the exposed surface 52 to create a third 3D stacked die 56. Likewise, during wafer scale operations, the second 3-D stacked wafer and the third 3-D stacked wafer 56.1, see Fig. 25, are created. Figs. 9-18 illustrate a sequence of steps creating electrical connectors 60, shown as a part of stacked multichip module 61 in Fig. 18, in contact with electrical conductors 24. Electrical connectors 60 connect the landing pads 98 of electrical conductors 24 at the different levels to contact pads 62. The different electrical connectors 60 are identified in Fig. 18 as electrical connectors 60.0 through 60.7 with the left most being 60.0. The locations for the electrical connectors 60 for contact with the corresponding electrical conductors 24 are labeled 0 through 7 in the figures. The position labeled GC identifies the location of ground connector 64 which typically electrically contacts electrical conductors 24 at each level. While only one electrical connector 60 is shown to contact an electrical conductor 24 at each level, in practice, many different electrical connectors 60 would be used to contact electrical conductors 24 at the same level. During wafer scale operations, the same basic processing steps are used on a third 3-D stacked wafer 56.1 to create an array of stacked multichip modules 61.

Fig. 9 shows the structure of Fig. 8 after creating an initial-processing photoresist mask 57 on dielectric material 54 followed by etching through dielectric material 54 down to hard mask layer 30. This creates openings 58 aligned with ground conductor location GC and electrical conductor locations 0-7.

A first photoresist mask 66, shown in Fig. 10, is created on the structure of Fig. 9 except for openings 58 at electrical conductor locations 1, 3, 5 and 7. These openings, which are aligned with the electrical conductors 24, are then etched one level through hard mask layer 30, electrical conductors 24 at the first, topmost levels 68, dielectric layer 26 and the silicon substrate 41 stopping just above electrical conductors 24 at the second level 70. While electrical connectors 60 are shown in the figures to be aligned in a row, other layouts are possible. For example, electrical connectors 60 could be arranged in a number of parallel or transversely extending rows. For example, electrical contact region 18 of Fig. 1 could include two or more rows of electrical connectors 60.

Next, as shown in Fig. 11, first photoresist mask 66 is removed and then a second photoresist mask 72 is formed on the resulting structure of Fig. 10 to cover ground conductor locations GC, electrical conductor locations 0, 1, 4, 5, and following location 7. The etching of two levels proceeds as follows. The portions of the resulting structure underlying locations 2 and 6 are etched two levels through first and second levels 68, 70 down to the electrical conductors 24 at those levels. The portions of the resulting structure underlying locations 3 and 7 are etched two levels through second and third levels 70, 74 down to the electrical conductors 24 at those levels. Doing so creates the structure shown in Fig. 11.

Next, second photoresist mask 72 is removed and a third photoresist mask 78 is formed to cover ground conductor location GC, electrical conductor locations 0, 1, 2, 3, and following location 7. The exposed portions of the structure overlying locations 4, 5, 6 and 7 are then etched four levels, that is down to fifth level 80, sixth level 82, seventh level 84 and eighth level 86 at locations 4, 5, 6 and 7, respectively, to create vias 77 in the structure of Fig. 12.

Third photoresist mask 78 is then removed followed by an isotropic etch of the exposed portions of substrates 41 at vias 77 to create recessed regions 88. See Fig. 13. An isotropic etch of electrical conductors 24 at vias 77 is then conducted to create conductor recessed regions 90 along the vias 77. These etching steps create modified vias 92.

Fig. 14 shows the results of lining modified vias 92 with a dielectric material 94, such as an oxide material 94, thus filling in recessed regions 88, 90 with the oxide material 94. Oxide material 94 could be, for example, SiN. The resulting vias 96 are extended to open onto the portions of the underlying electrical conductors 24 acting as landing pads 98.

Figs. 15-17 show processing steps used to form the electrical conductors 60 and ground conductor 64 shown in Fig. 18. In Fig. 15, a fourth photoresist mask 100 is shown covering everything except for ground conductor location GC. Fig. 15 also shows the result of etching through first through seventh levels 68, 70, 74, 76, 80, 82, 84 and down to electrical conductor 24 at eighth level 86 creating a ground conductor via 102. Fig. 16 shows result of an isotropic etching of substrates 41 at ground conductor via 102 to create recessed regions 104 opening onto ground conductor via 102. This is followed by the removal of fourth photoresist mask 100.

Fig. 17 illustrates the result of depositing an electrically insulating material 106, such as an organic material, for example a polymer, within recessed regions 104. In addition, the exposed dielectric material at layers 26 is etched back to create an enlarged ground conductor via 108. This causes an increase in the exposed sidewall contact surfaces of the electrical conductors 24 through which enlarged ground conductor via 108 passes.

Fig. 18 illustrates the structure of Fig. 17 following filling resulting vias 96 and enlarged ground conductor via 108 with a metal or other suitable electrical conductor to create ground connector 64 and electrical connectors 60.0-60.7. Doing so also creates three-dimensional stacked multichip module 61. Multichip module 61 is shown with contact pads 62 captured between multichip module 61 and a structure 110. The structure 110 could be, for example, a handling die or a die with active components, such as memory elements or logic devices, or a combination thereof, due to the flexibility provided by the technology. When structure 110 includes active components, structure 110 could be interconnected with stacked multichip module 61 through electrical connections to contact pads 62 and thus electrical connectors 60. Ground conductor 64 and electrical conductors 60 are lengths of substantially homogeneous electrically conductive material. By substantially homogeneous, it is meant herein that the conductors 60 lack physical boundaries between the levels. The conductors 60 are substantially homogeneous as used herein even if the conductive material used to form them includes multiple layers of different materials deposited in the vias, which may vary in relative concentration in each level as a result of the manufacturing process. This is in contrast to the electrical connectors formed by conventional TSV processes in which the electrical connectors within the individual via of each layer are separately formed and then are electrically connected to one another when the chips or wafers are stacked and bonded to one another, forming seams often with a separate conductive material joining the opposed electrode conductors.

While the die 12 used to form first 3D stacked die 48 of Fig. 6 could have electrical conductors 24 at different positions and patterns on the individual die, it may be preferred that the positions and patterns for electrical conductors for each die 12 be the same to facilitate manufacturing processes. In particular, it is typically desired that landing pads 98 at each level be aligned.

The above-described process for creating electrical connectors 60 can be referred to as a binary process, based on 2⁰... 2ⁿ⁻¹ with n being the number of etching steps. That is, first photoresist mask 66, see Fig. 10, alternatingly covers 2° landing pads 98 and exposes 2° landing pads 98; second photoresist mask 72, see Fig. 11, alternatingly covers 2¹ landing pads 98 and exposes 2¹ landing pads 98; third photoresist mask 78, see Fig. 12, alternatingly covers 2² landing pads 98 and exposes 2² landing pads 98; and so on. Using this binary process, n masks can be used to provide access to 2ⁿ landing pads 98 for 2ⁿ electrical conductors 24 at 2ⁿ levels. Thus, using 3 masks provides access to 8 landing pads 98 for 8 electrical conductors 24 at 8 levels. Using 5 masks would provide access to 32 landing pads 98 for 32 electrical conductors 24. The order of etching need not be in the order of n-1 = 0, 1, 2 .... For example, the first etching step could be with n-1= 2, the second could be with n-1 = 0, and the third could be with n-1 = 1. The result will be the same structure as shown in Fig. 12. During typical operations half of the contact openings are etched during each etching step. When the number of levels which can be etched is equal to or greater than the number of levels which are etched, such as when five photoresist masks are used to etch 29 contact openings to reach 29 different landing pads 98, the masks will not all be used to etch to half of the contact openings, but rather will be used to etch to what will be referred to as effectively half of the contact openings.

Figs. 19-21 are simplified plan views of three examples of die 12, each with one or more electrical contact region 18 and one or more regions of active device circuitry 20. The die 12 may all be the same or they could be different. For example, logic die such as CPU or controllers, could be used with memory die. In the example of Fig. 18, active device circuitry 20 constitutes a major portion of die 12 while electrical contact region 18 is positioned along one edge of die 12. In the example of Fig. 19, electrical contact region 18 is found at three different locations along three different sides of active device circuitry 20. In Fig. 20, there are two regions of active device circuitry 20 separated, in this example, by a single electrical contact region 18. It is expected that each die 12 will have many electrical contact regions like region 18 because one of the benefits of the stacked process is shorter connection path than with stacked chips using, for example, external bonding pads and connecting wires. It is expected that a minimum distance, such as 2 µm, be maintained between the one or more electrical contact regions 18 and active device circuitry 20. Such a minimum distance is likely to be required because of stresses induced by the process. Therefore, in some embodiments, the devices in one or more levels can include a wide I/O structuring, including many connectors, such as a hundred or more, between the levels. In other embodiments, fewer connectors between the levels are used.

An advantage of this invention is that it can be employed to create a three-dimensional, stacked multichip module, such as one including three-dimensional stacked memory devices, while drastically reducing the time and expense associated with the steps required to create conventional TSV stacked semiconductor devices. In addition, the invention reduces the required handling and processing of each die in comparison with conventional TSV procedures which can lead to improved yields. In addition to providing a thinner device, which is important for devices such as cell phones, the reduction in the thickness of the resulting stack of die 12 by the removal of lower portions 36 has several advantages. These advantages include reducing the length of the electrical connectors coupling electrical connectors 24 to one another and to landing pads 98, thus reducing the resistance and associated heat loss, and increasing speed.

The invention can be carried out using die scale stacking procedures, such as those discussed above, and can also be carried out using wafer scale stacking procedures which results in additional advantages discussed below. Fig. 22 is a top plan view illustrating an integrated circuit wafer 120 with grid lines 122 indicating die regions 123 where individual die 12 will be created from wafer 120. Fig. 23 shows a simplified cross-sectional view of a typical die 12, substantially identical to die 12 of Fig. 1, from location C-7 on wafer 120. In this example there are a total of 50 die 12 to be created from wafer 120. For purposes of illustration, it is assumed that 5 of the die 12 are defective or bad die 124 as indicated by being crosshatched in Fig. 22. In this case 90% of the die on wafer 120 would be good die 126 while 10% of die 120 would be bad die 124.

Fig. 24 illustrates an example in which four different IC wafers 120 each have 50 die regions 123 with 10% of die regions 123 being bad. If the IC wafers 120 are individually diced, then the good die can be selected and stacked using a die scale stacking technique resulting in a 90% yield for the stacked multichip modules 61. However, the need to individually process each multichip module 61 using die scale stacking techniques makes the processing much more expensive than processing on a wafer scale in which all 50 stacked multichip modules 61 are processed in unison.

IC wafers 120 of Fig. 24 are stacked to produce the third 3-D stacked wafer 56.1 of Fig. 25. Stacked wafer 56.1 has 15 of the die regions 123 marked with either a 2, indicating two out of the four stacked die are good die, or 3, indicating three out of the four stacked die are good die. No marking indicates that all levels are good die. If the four different IC wafers 120 are stacked, bonded to one another, diced and then processed in a conventional manner, such as using wirebonding techniques or TSV, each stacked multichip module with even one bad die would cause that stacked multichip module to be rejected as defective because all of the die need to be good for the stacked multichip module to be good. In this example the yield would be only 70% good stacked multichip modules, that is 35 out of 50. This technique would, however, eliminate the processing expenses associated with die scale stacking and processing techniques discussed in the paragraph immediately above.

With the present invention the stacked multi-die modules 61 which are partially defective can be segregated as non-perfect die. For example, if each die 12 is one core of a CPU, the non-perfect module 61 can be identified as a two core module 61 if there are two good die 12 or a three core module 61 if there are three good die 12. Similarly, if each die is a 1 GB memory die, the non-perfect modules 61 can be marked as 3 GB memory modules or 2 GB memory modules as the case may be. In this example there would be 35 good stacked multichip module 61 but also 5 non-perfect modules 61 with two good die 12 and 10 non-perfect modules 61 with three good die 12. The interconnection technology described herein enables isolation of the defective die in the stack, because of the individual connectors reaching to a single landing pad on one level of the stack. During the manufacturing process to stack the die and make the connectors, the defective die can be isolated from operable die, in one approach, using masks for the formation of the connectors that are selected according to the number and locations of the defective die in each stack. Being able to salvage the non-perfect module 61 helps to reduce cost over conventional wafer scale processing techniques.

The above descriptions may have used terms such as above, below, top, bottom, over, under, et cetera. These terms may be used in the description and claims to aid understanding of the invention and not used in a limiting sense.

While the present invention is disclosed by reference to the preferred embodiments and examples detailed above, it is to be understood that these examples are intended in an illustrative rather than in a limiting sense. It is contemplated that modifications and combinations will occur to those skilled in the art, which modifications and combinations will be within the scope of the following claims.

## Claims

1. A three-dimensional stacked module (61) comprising:
a set of W dies (12) in a stack, wherein W ≥ 2, each die (12) in the stack comprising an electrical contact region (18) over a substrate (28, 41), the electrical contact region (18) comprising a plurality of pads (24);
the stack of dies (12) comprising a first die (12) at one end of the stack and a second die (12) at the other end of the stack, the substrate (28, 41) of the first die (12) facing the plurality of pads (24) of the second die (12);
the plurality of pads (24) on each die (12) being aligned with those on the one or more other dies (12) in the stack, the plurality of pads (24) on each die (12) including one single selected pad called landing pad (98);
a set of W-1 electrical connectors (60) extending from the surface of the first die (12) including the contact region (18) and into the stack of dies (12) to electrically contact W-1 landing pads (98) through vias (96), one further electrical connector (60) electrically contacting the landing pad (98) of the first die (12), to create a three-dimensional stacked multichip module (61) having W die levels (68, 70, 74, 76, 78, 82, 84, 86), wherein each of said electrical connectors (60) reaches and electrically connects to one single landing pad (98) in the stack of dies (12), the one or more substrates (41) and the one or more pads (24) above the landing pad (98) along each via (96) being each provided with recessed regions (88, 90), and the vias (96) being lined with a dielectric material (94) filling in the recessed regions (88, 90).

2. The module according (61) to claim 1, wherein the electrical contact region (18) locates a patterned conductor layer (22) over the substrate (28, 41), and the substrate (41) of the first die facing the patterned conductor layer of the second die.

3. The module (61) according to claim 1 or 2, wherein the landing pads (98) are arranged in a stair stepped arrangement.

4. The module (61) according to claim 3, wherein the module (61) locates in a three-dimensional stacked multi-wafer device, and the device comprising:
a stack of integrated circuit wafers (120);
each integrated circuit wafer (120) comprising a grid of die regions (123);
at least some of the die regions for each integrated circuit wafer being aligned with die regions of the other integrated circuit wafers of the stack of integrated circuit wafers; and each die region (123) comprising the module (61).

5. The module (61) according to any of claims 1 to 4, wherein at least some of the dies (12) comprise device circuitry (20) at a device circuitry location spaced apart from the electrical contact region (18).

6. The module (61) according to claim 5, wherein the device circuitry (20) for at least one of the dies (12) occupies a first portion of the die (12) and the electrical contact region (18) occupies first and second portions of the die (12) on different sides of the device circuitry (20).

7. The module according to claim 5, wherein the device circuitry (20) for the one of the dies (12) occupies first and second spaced apart portions of the die (12) and the electrical contact region (18) occupies a third portion between the first and second portions.

8. The module according to any of claims 1 to 7, further comprising a dielectric material layer over the electrical contact region (18) of the first die (12).

9. A method for creating a three-dimensional stacked module (61) comprising:
providing a set of W integrated circuit dies (12), wherein W ≥ 2, each die (12) in the set comprising a patterned conductor layer (22), the patterned conductor layer (22) comprising an electrical contact region (18), the electrical contact region (18) comprising pads (24);
mounting a handling die (34) to a selected die (12) in the set, over the patterned conductor layer (22);
removing an exposed layer of the selected die (12) to create an enhanced handling die (38);
mounting the enhanced handling die (38) on a top of a further die (42) in the set;
removing a lower portion of a substrate (28) of the further die (42) in the set;
repeating the mounting and removing steps using the further die (42) in the set to form a stack of dies (48), and so that the pads (24) on each die are aligned with those on the one or more other dies in the set, the pads on each die including one single selected pad called landing pad (98), until all the dies in the set are mounted, to create a three-dimensional stacked die (48), the selected die (12) being the first die in said three-dimensional stacked die (48);
depositing dielectric material (54) on the first die of said three-dimensional stacked die;
creating contact openings (58) in the dielectric material (54) by removing at least a portion of the dielectric material (54), each of said contact openings (58) overlying one pad (24) of the first die, and creating vias (96) by etching through the contact openings (58); and
forming a set of W electrical connectors (60) in the contact openings (58) and in the vias (96) through the three-dimensional stacked die (48) to create a three-dimensional stacked module (61), wherein each of said electrical connectors (60) reaches and electrically connects to a single landing pad (98) in the set of dies, wherein
the electrical connectors forming step comprises creating recessed regions (88, 90) in each of the one or more substrates (41) and the one or more pads (24) above the landing pad (98) along each via (96) and lining the vias (96) with a dielectric material (94) filling in the recessed regions (88, 90).

10. The method according to claim 9, wherein the forming step is carried out with at least some of the die comprising device circuitry (20) at a device circuitry location spaced apart from the electrical contact region (18).

11. The method according to claim 9, wherein the mounting step further comprises depositing a dielectric, adhesion-enhancing layer (30) between the handling die (34) and the die (12).

12. The method according to claim 9, wherein the die providing step further comprises selecting a die (12) comprising the substrate (28) having a first side at which the patterned conductor region (22) is located, and a second side opposite the first side.

13. The method according to claim 12, wherein the removing step comprises removing a portion of the second side of the substrate (28).

14. The method according to claim 9, further comprising removing at least a portion of the handling die (34) from the three-dimensional stacked module to create an exposed surface.

15. The method according to claim 9, wherein the electrical connectors forming step comprises:
selecting a set of N etch masks (66, 72, 78), N being selected so that 2^{N-1} is less than W and 2^{N} is greater than or equal to W;
using the N masks (66, 72, 78) to etch the contact openings (58) to the W die levels (68, 70, 74, 76, 78, 82, 84, 86) to create the vias (96), the N masks (66, 72, 78) using step comprising etching 2ⁿ⁻¹ die levels for each mask n = 1,2...N to create the vias (96); and
whereby electrical conductors (60) can be formed in the vias (96) to electrically contact landing pads (98) at each of the die levels (68, 70, 74, 76, 78, 82, 84, 86).

16. The method according to claim 15, further comprising covering said surface of the module with the dielectric material (54) following the handling die removing step; and
wherein the contact openings creating step further comprises removing at least a portion of the second dielectric material (54).

17. The method according to claim 15, wherein the N etch masks using step further comprises alternatingly covering and exposing 2ⁿ⁻¹ landing pads for each mask n = 1,2...N.

18. A method for creating a plurality of three-dimensional stacked modules (61) comprising:
providing a set of W integrated circuit wafers (120), wherein W ≥ 2, each wafer (120) in the set comprising a grid of die regions (123), each die region (123) comprising an integrated circuit die (12) comprising a patterned conductor layer (22), the patterned conductor layer (22) comprising an electrical contact region (18), the electrical contact region (18) comprising pads (24);
mounting a handling wafer to a selected wafer (120) in the set, over the patterned conductor layers (22);
removing an exposed layer of the selected wafer (120) to create an enhanced handling wafer;
mounting the enhanced handling wafer on a top of a further wafer (120) in the set;
removing a lower portion of a substrate of the further wafer (120) in the set;
repeating the mounting and removing steps using the further wafer in the set to form a stack of wafers, and so that the pads (24) on each die are aligned with those on the one or more other dies in the set of integrated circuit wafers, the pads (24) on each die including one single selected pad called landing pad (98), until all the wafers in the set are mounted, to create a three-dimensional stacked wafer comprising a grid of three-dimensional stacked die, the selected wafer being the first wafer in said three-dimensional stacked wafer;
depositing dielectric material (54) on the first wafer of said three-dimensional stacked wafer;
creating contact openings (58) in the dielectric material (54) by removing at least a portion of the dielectric material (54), each of said contact openings overlying one pad (24) of one of the die regions of the first wafer, and creating vias (96) by etching through the contact openings; and
forming a set of W electrical connectors (60) in the contact openings (58) and in the vias (96) to create a grid of three-dimensional stacked modules (61), wherein each electrical connector (60) reaches and electrically connects to a single landing pad (98) in the set of wafers; and
physically separating the grid of three-dimensional stacked modules into individual three-dimensional stacked modules (61), wherein
the electrical connectors forming step comprises creating recessed regions (88, 90) in each of the one or more substrates (41) and the one or more pads (24) above the landing pad (98) along each via (96) and lining the vias (96) with a dielectric material (94) filling in the recessed regions (88, 90).

## Patentansprüche

1. Dreidimensional gestapeltes Modul (61), umfassend
einen Satz von W Plättchen (12) in einem Stapel, wobei W ≥ 2, wobei jedes Plättchen (12) in dem Stapel einen elektrischen Kontaktbereich (18) über einem Substrat (28, 41) umfasst, wobei der elektrische Kontaktbereich (18) eine Vielzahl von Anschlussflächen (24) umfasst;
wobei der Stapel von Plättchen (12) ein erstes Plättchen (12) an einem Ende des Stapels und ein zweites Plättchen (12) am anderen Ende des Stapels umfasst, wobei das Substrat (28, 41) des ersten Plättchens (12) der Vielzahl von Anschlussflächen (24) dem zweiten Plättchen (12) zugewandt ist;
wobei die Vielzahl von Anschlussflächen (24) auf jedem Plättchen (12) mit denen auf dem einen oder mehreren anderen Plättchen (12) in dem Stapel ausgerichtet ist, wobei die Vielzahl von Anschlussflächen (24) auf jedem Plättchen (12) eine einzelnes ausgewählte Anschlussfläche, genannt Landeanschlussfläche (98), enthält;
einen Satz von W-1 elektrischen Verbindern (60), die sich von der Oberfläche des ersten Plättchens (12) einschließlich des Kontaktbereichs (18) und in den Stapel von Plättchen (12) erstrecken, um W-1 Landeanschlussflächen (98) durch Durchgangslöcher (96) elektrisch zu kontaktieren, wobei ein weiterer elektrischer Verbinder (60) die Landeanschlussfläche (98) des ersten Plättchens (12) elektrisch kontaktiert, um ein dreidimensional gestapeltes Multiplättchen-Modul (61) mit W Plättchenebenen (68, 70, 74, 76, 78, 82, 84, 86), wobei jeder der elektrischen Verbinder (60) eine einzelne Landeanschlussfläche (98) in dem Stapel von Plättchen (12) erreicht und elektrisch mit ihm verbunden ist, wobei das eine oder die mehreren Substrate (41) und der eine oder die mehreren Anschlussflächen (24) oberhalb der Landeanschlussfläche (98) entlang jedem Durchgangsloch (96) jeweils mit ausgesparten Bereichen (88, 90) versehen sind, und wobei die Durchgangslöcher (96) mit einem dielektrischen Material (94) ausgekleidet sind, das die ausgesparten Bereiche (88, 90) ausfüllt.

2. Modul nach Anspruch 1 (61), wobei der elektrische Kontaktbereich (18) eine strukturierte Leiterschicht (22) über dem Substrat (28, 41) anordnet und das Substrat (41) des ersten Plättchens der strukturierten Leiterschicht dem zweiten Plättchen gegenüberliegt.

3. Modul (61) nach Anspruch 1 oder 2, bei dem die Landeanschlussflächen (98) treppenförmig abgestuft angeordnet sind.

4. Modul (61) nach Anspruch 3, wobei sich das Modul (61) in einer dreidimensional gestapelten Multi-Wafer-Vorrichtung befindet, und die Vorrichtung umfasst:
einen Stapel von Wafern mit integrierten Schaltkreisen (120);
wobei jeder Wafer mit integrierten Schaltkreisen (120) ein Gitter von Plättchenbereichen (123) aufweist;
wobei zumindest einige der Plättchenbereiche für jeden Wafer mit integrierte Schaltkreis mit Plättchenbereichen der anderen Wafer mit integriertem Schaltkreis des Stapels von Wafern mit integriertem Schaltkreis ausgerichtet sind; und wobei jeder Plättchenbereich (123) das Modul (61) umfasst.

5. Modul (61) nach einem der Ansprüche 1 bis 4, wobei mindestens einige der Plättchen (12) eine Bauelementeschaltung (20) an einem Bauelementeschaltungsort aufweisen, der von dem elektrischen Kontaktbereich (18) beabstandet ist.

6. Modul (61) nach Anspruch 5, wobei die Bauelementeschaltung (20) für mindestens eines der Plättchen (12) einen ersten Abschnitt des Plättchens (12) belegt und der elektrische Kontaktbereich (18) einen ersten und einen zweiten Abschnitt des Plättchens (12) auf verschiedenen Seiten der Bauelementeschaltung (20) belegt.

7. Modul nach Anspruch 5, wobei die Bauelementeschaltung (20) für das eine der Plättchen (12) einen ersten und einen zweiten beabstandeten Abschnitt des Plättchens (12) belegt und der elektrische Kontaktbereich (18) einen dritten Abschnitt zwischen dem ersten und dem zweiten Abschnitt belegt.

8. Modul nach einem der Ansprüche 1 bis 7, das ferner eine Schicht aus dielektrischem Material über dem elektrischen Kontaktbereich (18) des ersten Plättchens (12) umfasst.

9. Verfahren zur Erzeugung eines dreidimensional gestapelten Moduls (61), umfassend
Bereitstellen eines Satzes von W integrierten Schaltungsplättchen (12), wobei W ≥ 2, wobei jedes Plättchen (12) in dem Satz eine strukturierte Leiterschicht (22) umfasst, wobei die strukturierte Leiterschicht (22) einen elektrischen Kontaktbereich (18) umfasst, wobei der elektrische Kontaktbereich (18) Anschlussflächen (24) umfasst;
Montieren eines Handhabungsplättchens (34) auf ein ausgewähltes Plättchen (12) im Satz über der strukturierten Leiterschicht (22);
Entfernen einer freiliegenden Schicht des ausgewählten Plättchens (12), um ein verbessertes Handhabungsplättchen (38) zu erzeugen;
Montieren des verbesserten Handhabungsplättchens (38) auf einer Oberseite eines weiteren Plättchens (42) im Satz;
Entfernen eines unteren Teils eines Substrats (28) der weiteren Plättchens (42) in dem Satz;
Wiederholen der Montage- und Entfernungsschritte unter Verwendung des weiteren Plättchens (42) in dem Satz, um einen Stapel von Plättchen (48) zu bilden, und so, dass die Anschlussflächen (24) auf jedem Plättchen mit denen auf dem einen oder mehreren anderen Plättchen in dem Satz ausgerichtet sind, wobei die Anschlussflächen auf jedem Plättchen eine einzelne ausgewählte Anschlussfläche enthalten, die als Landeanschlussfläche (98) bezeichnet wird, bis alle Plättchen in dem Satz montiert sind, um ein dreidimensional gestapeltes Plättchen (48) zu erzeugen, wobei das ausgewählte Plättchen (12) das erste Plättchen in dem dreidimensional gestapelten Plättchen (48) ist;
Abscheiden von dielektrischem Material (54) auf dem ersten Plättchen des dreidimensional gestapelten Plättchens;
Erzeugen von Kontaktöffnungen (58) in dem dielektrischen Material (54) durch Entfernen mindestens eines Teils des dielektrischen Materials (54), wobei jede der Kontaktöffnungen (58) über einer Anschlussfläche (24) des ersten Plättchens liegt, und Erzeugen von Durchgangslöchern (96) durch Ätzen durch die Kontaktöffnungen (58); und
Bilden eines Satzes von W elektrischen Verbindern (60) in den Kontaktöffnungen (58) und in den Durchgangslöchern (96) durch das dreidimensional gestapelte Plättchen (48), um ein dreidimensional gestapeltes Modul (61) zu erzeugen, wobei jeder der elektrischen Verbinder (60) eine einzelne Landeanschlussfläche (98) in dem Satz von Plättchen erreicht und elektrisch mit diesem verbunden ist, wobei
der Schritt des Bildens elektrischer Verbinder Erzeugen ausgesparter Bereiche (88, 90) in jedem des einen oder der mehreren Substrate (41) und des einen oder der mehreren Anschlussflächen (24) oberhalb der Landeanschlussfläche (98) entlang jedes Durchgangslochs (96) und Auskleiden der Durchgangslöcher (96) mit einem dielektrischen Material (94), das die ausgesparten Bereiche (88, 90) ausfüllt, umfasst.

10. Verfahren nach Anspruch 9, bei dem der Bildungsschritt ausgeführt wird, bei dem mindestens ein Teil des Plättchens eine Bauelementeschaltung (20) an einem Bauelementeschaltungsort aufweist, der von dem elektrischen Kontaktbereich (18) beabstandet ist.

11. Verfahren nach Anspruch 9, wobei der Montageschritt ferner Abscheiden einer dielektrischen, haftungsverstärkenden Schicht (30) zwischen dem Handhabungsplättchen (34) und dem Plättchen (12) umfasst.

12. Verfahren nach Anspruch 9, wobei der Schritt des Bereitstellens eines Plättchens (12) ferner Auswählen eines Plättchens (12) umfasst, das das Substrat (28) mit einer ersten Seite, auf der sich die strukturierte Leiterschicht (22) befindet, und einer zweiten Seite gegenüber der ersten Seite umfasst.

13. Verfahren nach Anspruch 12, wobei der Entfernungsschritt Entfernen eines Teils der zweiten Seite des Substrats (28) umfasst.

14. Verfahren nach Anspruch 9, ferner umfassend Entfernen mindestens eines Teils des Handhabungsplättchens (34) von dem dreidimensional gestapelten Modul, um eine freiliegende Oberfläche zu schaffen.

15. Verfahren nach Anspruch 9, wobei der Schritt des Bildens elektrischer Verbinder umfasst:
Auswahl eines Satzes von N Ätzmasken (66, 72, 78), wobei N so gewählt wird, dass 2^{N-1} kleiner als W und 2^{N} größer oder gleich W ist;
Verwendung der N Masken (66, 72, 78) zum Ätzen der Kontaktöffnungen (58) zu den W Plättchenebenen (68, 70, 74, 76, 78, 82, 84, 86), um die Durchgangslöcher (96) zu erzeugen, wobei die N Masken (66, 72, 78) einen Schritt verwenden, der das Ätzen von 2ⁿ⁻¹ Plättchenebenen für jede Maske n = 1,2...N umfasst, um die Durchgangslöcher (96) zu erzeugen; und
wobei elektrische Leiter (60) in den Durchgangslöchern (96) gebildet werden können, um Landeanschlussflächen (98) auf jeder der Plättchenebenen (68, 70, 74, 76, 78, 82, 84, 86) elektrisch zu kontaktieren.

16. Verfahren nach Anspruch 15, ferner umfassend Bedecken der Oberfläche des Moduls mit dem dielektrischen Material (54) nach dem Schritt des Entfernens der Handhabungsplättchen; und
wobei der Schritt des Erzeugens der Kontaktöffnungen ferner Entfernen mindestens eines Teils des zweiten dielektrischen Materials (54) umfasst.

17. Verfahren nach Anspruch 15, wobei der Schritt des Verwendens der N Ätzmasken ferner abwechselndes Abdecken und Freigeben von 2ⁿ⁻¹ Landeanschlussflächen für jede Maske n = 1,2...N umfasst.

18. Verfahren zum Erzeugen einer Vielzahl von dreidimensional gestapelten Modulen (61), umfassend:
Bereitstellen eines Satzes von W Wafern (120) mit integrierter Schaltung, wobei W ≥ 2, wobei jeder Wafer (120) in dem Satz ein Gitter von Plättchenbereichen (123) aufweist, wobei jeder Plättchenbereich (123) ein Plättchen (12) mit integrierter Schaltung aufweist, das eine strukturierte Leiterschicht (22) aufweist, wobei die strukturierte Leiterschicht (22) einen elektrischen Kontaktbereich (18) aufweist, wobei der elektrische Kontaktbereich (18) Anschlussflächen (24) aufweist;
Montieren eines Handhabungswafers auf einen ausgewählten Wafer (120) im Satz über den strukturierten Leiterschichten (22);
Entfernen einer freiliegenden Schicht des ausgewählten Wafers (120), um einen verbesserten Handhabungswafer zu erzeugen;
Montieren des verbesserten Handhabungswafers auf eine Oberseite eines weiteren Wafers (120) im Satz;
Entfernen eines unteren Teils eines Substrats des weiteren Wafers (120) im Satz;
Wiederholen der Montage- und Entfernungsschritte unter Verwendung des weiteren Wafers in dem Satz, um einen Stapel von Wafern zu bilden, und so, dass die Anschlussflächen (24) auf jedem Plättchen mit denen auf dem einen oder mehreren anderen Plättchen in dem Satz von Wafern mit integrierten Schaltungen ausgerichtet sind, wobei die Anschlussflächen (24) auf jedem Plättchen eine einzelne ausgewählte Anschlussfläche aufweisen, die Landeanschlussfläche (98) genannt wird, bis alle Wafer in dem Satz montiert sind, um einen dreidimensional gestapelten Wafer zu erzeugen, der ein Gitter von dreidimensional gestapelten Plättchen umfasst, wobei der ausgewählte Wafer der erste Wafer in dem dreidimensional gestapelten Wafer ist;
Abscheiden von dielektrischem Material (54) auf dem ersten Wafer des dreidimensional gestapelten Wafers;
Erzeugen von Kontaktöffnungen (58) in dem dielektrischen Material (54) durch Entfernen mindestens eines Teils des dielektrischen Materials (54), wobei jede der Kontaktöffnungen über einer Anschlussfläche (24) eines der Plättchenbereiche des ersten Wafers liegt, und Erzeugen von Durchgangslöchern (96) durch Ätzen durch die Kontaktöffnungen; und
Bilden eines Satzes von W elektrischen Verbindern (60) in den Kontaktöffnungen (58) und in den Durchgangslöchern (96), um ein Gitter von dreidimensional gestapelten Modulen (61) zu erzeugen, wobei jeder elektrische Verbinder (60) eine einzelne Landeanschlussfläche (98) in dem Satz von Wafern erreicht und elektrisch mit ihm verbunden ist; und
physikalisches Trennen des Gitters dreidimensional gestapelter Module in einzelne dreidimensional gestapelte Module (61), wobei
der Schritt des Bildens elektrischer Verbinder Erzeugen ausgesparter Bereiche (88, 90) in jedem des einen oder der mehreren Substrate (41) und des einen oder der mehreren Anschlussflächen (24) oberhalb der Landeanschlussfläche (98) entlang jedes Durchgangslochs (96) und Auskleiden der Durchgangslöcher (96) mit einem dielektrischen Material (94), das die ausgesparten Bereiche (88, 90) ausfüllt, umfasst.

## Revendications

1. Module empilé tridimensionnel (61) comprenant :
un ensemble de W puces (12) dans un empilement, W étant ≥ 2, chaque puce (12) dans l'empilement comprenant une région de contact électrique (18) sur un substrat (28, 41), la région de contact électrique (18) comprenant une pluralité de plots (24) ;
l'empilement de puces (12) comprenant une première puce (12) à une extrémité de l'empilement et une seconde puce (12) à l'autre extrémité de l'empilement, le substrat (28, 41) de la première puce (12) faisant face à la pluralité de plots (24) de la seconde puce (12) ;
la pluralité des plots (24) sur chaque puce (12) étant alignée avec ceux sur lesdites autres puces (12) dans l'empilement, la pluralité de plots (24) sur chaque puce (12) comprenant un seul plot sélectionné appelé plot de réception (98) ;
un ensemble de W-1 connecteurs électriques (60) partant depuis la face de la première puce (12) comprenant la région de contact (18) et dans l'empilement des puces (12) jusqu'aux plots de réception W-1 de contact électrique (98) traversant des trous d'interconnexion (96), un autre connecteur électrique (60) en contact électrique avec le plot de réception (98) de la première puce (12), pour créer un module multipuce empilé tridimensionnel (61) ayant des niveaux de W puce (68, 70, 74, 76, 78, 82, 84, 86), chacun desdits connecteurs électriques (60) atteignant un seul plot de réception (98) dans l'empilement de puces (12) et étant en contact avec celui-ci, ledit au moins un substrat (41) et lesdits plots (24) au-dessus du plot de réception (98) le long de chaque trou d'interconnexion (96) étant chacun pourvu de régions en creux (88, 90), et les trous d'interconnexion (96) étant garnis d'un matériau diélectrique (94) remplissant les régions en creux (88, 90).

2. Module (61) selon la revendication 1, la région de contact électrique (18) localisant une couche conductrice à motifs (22) sur le substrat (28, 41), et le substrat (41) de la première puce faisant face à la couche conductrice à motifs de la seconde puce.

3. Module (61) selon la revendication 1 ou la revendication 2, les plots de réception (98) étant disposés selon un montage en escalier.

4. Module (61) selon la revendication 3, le module (61) situé dans un dispositif multi tranche empilé tridimensionnel, et le dispositif comprenant :
un empilement de tranches de circuit intégré (120) ;
chaque tranche de circuit intégré (120) comprenant une grille de régions de puces (123) ;
au moins certaines régions de puce pour chaque tranche de circuit intégré étant alignées avec les régions de puce des autres tranches de circuit intégré de l'empilement des tranches de circuit intégré ; et chaque région de puce (123) comprenant le module (61).

5. Module (61) selon l'une quelconque des revendications 1 à 4, au moins certaines des puces (12) comprenant des circuits de dispositif (20) à un emplacement de circuits de dispositif espacé de la région de contact électrique (18).

6. Module (61) selon la revendication 5, les circuits de dispositif (20) pour au moins l'une des puces (12) occupant une première partie de la puce (12) et la région de contact électrique (18) occupant la première et la deuxième partie de la puce (12° sur des côtés différents des circuits de dispositif (20).

7. Module (61) selon la revendication 5, les circuits de dispositif (20) pour l'une des puces (12) occupant la première et la deuxième partie espacée de la puce (12) et la région de contact électrique (18) occupant une troisième partie entre la première et la seconde partie.

8. Module (61) selon l'une quelconque des revendications 1 à 7, comprenant en outre un matériau diélectrique (54) sur la région de contact électrique (18) de la première puce (12).

9. Procédé de création d'un module empilé tridimensionnel (61) consistant à :
fournir un ensemble de W puces de circuit intégré (12), W étant ≥ 2, chaque puce (12) dans l'ensemble comprenant une couche conductrice à motifs (22), la couche conductrice à motifs (22) comprenant une région de contact électrique (18), la région de contact électrique (18) comprenant des plots (24) ;
monter une puce de pilotage (34) sur une puce sélectionnée (12) dans l'ensemble, sur la couche conductrice à motifs (22) ;
monter la puce de pilotage améliorée (38) sur la partie supérieure d'une autre puce (42) dans l'ensemble ;
retirer une partie inférieure d'un substrat (28) de l'autre puce (42) dans l'ensemble ;
répéter les étapes de montage et de retrait à l'aide de l'autre puce (42) dans l'ensemble pour former un empilement de puces (48), et de manière à ce que les plots (24) sur chaque puce soient alignés avec ceux sur lesdites autres puces dans l'ensemble, les plots sur chaque puce comprenant un seul plot sélectionné appelé plot de réception (98), jusqu'à ce que toutes les puces soient montées dans l'ensemble, pour créer une puce empilée tridimensionnelle (48), la puce sélectionné (12) étant la première puce dans ladite puce empilée tridimensionnelle (48) ;
déposer le matériau diélectrique (54) sur la première puce de ladite puce empilée tridimensionnelle ;
créer des orifices de contact (58) dans le matériau diélectrique (54) par retrait au moins d'une partie du matériau diélectrique (54) chacun des orifices de contact (58) chevauchant un plot (24) de la première puce, et créer des trous d'interconnexion par gravure à travers les orifices de contact (58) ; et
former un ensemble de W-1 connecteurs électriques (60) dans les orifices de contact (58) et dans les trous d'interconnexion (96) par la puce empilée tridimensionnelle (48) pour créer un module empilé tridimensionnel (61), chacun desdits connecteurs électriques (60) atteignant un seul plot de réception (98) dans l'ensemble des puces (12) et étant en contact avec celui-ci,
l'étape de formation des connecteurs électriques consistant à créer des régions en creux (88, 90) dans chacun desdits substrats (41) et desdits plots (24) au-dessus du plot de réception (98) le long de chaque trou d'interconnexion (96) et à garnir les trous d'interconnexion (96) d'un matériau diélectrique (94) remplissant les régions en creux (88, 90).

10. Procédé selon la revendication 9, l'étape de formation étant effectué avec au moins certaines des puces comprenant les circuits de dispositif (20) à un emplacement de circuits de dispositif espacé de la région de contact électrique (18).

11. Procédé selon la revendication 9, l'étape de montage consistant en outre à déposer une couche diélectrique (30) améliorant l'adhérence entre la puce de pilotage (34) et la puce (12).

12. Procédé selon la revendication 9, l'étape de fourniture de puce consistant en outre à sélectionner une puce (12) comprenant le substrat (28) ayant un premier côté sur lequel est située la région conductrice à motifs (22) et un second côté en regard du premier côté.

13. Procédé selon la revendication 12, l'étape de retrait consistant à retirer une partie du second côté du substrat (28).

14. Procédé selon la revendication 9, consistant en outre à retirer au moins une partie de la puce de pilotage (34) du module empilé tridimensionnel pour créer une surface apparente.

15. Procédé selon la revendication 9, l'étape de formation des connecteurs électriques consistant à :
sélectionner un ensemble de N masques de gravure (66, 72, 78), N étant sélectionné de sorte que 2^{N-1} soit inférieur à W et 2^{N} soit supérieur ou égal à W ;
utiliser les N masques (66, 72, 78) pour graver les orifices de contact (58) aux niveaux de W puces (68, 70, 74, 76, 78, 82, 84, 86) pour créer les trous d'interconnexion (96), les N masques (66, 72, 78) utilisant l'étape consistant à graver 2^{N-1} niveaux de puce pour chaque masque n = 1, 2... N pour créer les trous d'interconnexion (96) ; et
les conducteurs électriques (60) pouvant être formés dans les trous de connexion (96) pour mettre en contact électrique les plots de réception (98) avec chacun des niveaux de puce (68, 70, 74, 76, 78, 82, 84, 86).

16. Procédé selon la revendication 15, consistant en outre à recouvrir ladite surface du module de matériau diélectrique (54) après l'étape de retrait de la puce de pilotage ; et
l'étape de création d'orifices de contact consistant en outre à retirer au moins une partie du second matériau diélectrique (54).

17. Procédé selon la revendication 15, l'étape d'utilisation des N masques de gravure consistant en outre à recouvrir en alternance et à rendre apparents les 2^{N-1} plots de réception pour chaque masque n = 1, 2....N.

18. Procédé de création d'une pluralité de modules empilés tridimensionnels (61) consistant à :
fournir un ensemble de W tranches de circuit intégré (120), W étant ≥ 2, chaque tranche (120) dans l'ensemble comprenant une grille des régions de puce (123), chaque région de puce (123) comprenant une puce de circuit intégré (12) comprenant une couche conductrice à motifs (22), la couche conductrice à motifs (22) comprenant une région de contact électrique (18), et la région de contact électrique (18) comprenant des plots (24) ;
monter une tranche de pilotage sur une tranche sélectionnée (120) dans l'ensemble, sur les couches conductrices à motifs (22) ;
retirer une couche apparente de la tranche sélectionnée (120) pour créer une tranche de pilotage améliorée ;
monter la tranche de pilotage améliorée sur une partie supérieure d'une autre tranche (120) dans l'ensemble ;
retirer une partie inférieure d'un substrat de l'autre tranche (120) dans l'ensemble ;
répéter les étapes de montage et de retrait utilisant l'autre tranche dans l'ensemble pour former un empilement de tranches, et de manière à ce que les plots (24) sur chaque puce soient alignés avec ceux desdites autres puces dans l'ensemble de tranches de circuit intégré, les plots (24) sur chaque puce comprenant un seul plot sélectionné appelé plot de réception (98), jusqu'à ce que toutes les tranches dans l'ensemble soient montées, pour créer une tranche empilée tridimensionnelle comprenant une grille de puce empilée tridimensionnelle, la tranche sélectionnée étant la première tranche dans ladite tranche empilée tridimensionnelle ;
déposer un matériau diélectrique (54) sur la première tanche de ladite tranche empilée tridimensionnelle ;
créer des orifices de contact (58) dans le matériau diélectrique (54) par retrait d'au moins une partie du matériau diélectrique (54), chacun desdits orifices de contact chevauchant un plot (24) de l'une des régions de puce de la première tranche, et créer des trous d'interconnexion (96) par gravure à travers les orifices de contact ; et
former un ensemble de W connecteurs électriques (60) dans les orifices de contact (58) et dans les trous d'interconnexion (96) pour créer une grille de modules empilés tridimensionnels (61), chaque connecteur électrique (60) rejoignant et se connectant électriquement à un seul plot de réception (98) dans l'ensemble des tranches ; et
séparer physiquement la grille de modules empilés tridimensionnels en des modules empilés tridimensionnels (61) individuels,
l'étape de formation des connecteurs électriques consistant à créer des régions en creux (88, 90) dans chacun desdits substrats (41) et dans lesdits plots (24) au-dessus du plot de réception (98) le long de chaque trou d'interconnexion (96) et à garnir les trous d'interconnexion (96) de matériau diélectrique (94) remplissant les régions en creux (88, 90).
